(19) **Europäisches Patentamt / European Patent Office / Office européen des brevets**

(11) **EP 4 086 822 B1**

(12) **FASCICULE DE BREVET EUROPEEN**

(45) Date de publication et mention
de la délivrance du brevet:
**23.04.2025 Bulletin 2025/17**

(21) Numéro de dépôt: **22169785.7**

(22) Date de dépôt: **25.04.2022**

(51) Classification Internationale des Brevets (IPC):
***G06N 10/40*** *(2022.01)*

(52) Classification Coopérative des Brevets (CPC):
**G06N 10/40**

(54) **DISPOSITIF COMPORTANT DES ELEMENTS DE COMPENSATION DE LA VARIABILITE LOCALE DE POTENTIEL ELECTROSTATIQUE**

VORRICHTUNG MIT ELEMENTEN ZUR KOMPENSATION DER LOKALEN VARIABILITÄT DES ELEKTROSTATISCHEN POTENZIALS

DEVICE COMPRISING ELEMENTS FOR COMPENSATING LOCAL VARIABILITY OF ELECTROSTATIC POTENTIAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.05.2021 FR 2104871**

(43) Date de publication de la demande:
**09.11.2022 Bulletin 2022/45**

(73) Titulaires:
• **Commissariat à l'Energie Atomique et aux Energies Alternatives**
**75015 Paris (FR)**
• **Centre National de la Recherche Scientifique**
**75794 Paris Cedex 16 (FR)**

(72) Inventeurs:
• **VINET, Maud**
**38054 GRENOBLE CEDEX 09 (FR)**
• **BERTRAND, Benoît**
**38054 GRENOBLE CEDEX 09 (FR)**

• **MEUNIER, Tristan**
**38000 GRENOBLE (FR)**

(74) Mandataire: **Brevalex**
**Tour Trinity**
**1 B Place de la Défense**
**92400 Courbevoie (FR)**

(56) Documents cités:
• **VELDHORST M ET AL: "Silicon CMOS architecture for a spin-based quantum computer", ARXIV.ORG, CORNELL UNIVERSITY LIBRARY, 201 OLIN LIBRARY CORNELL UNIVERSITY ITHACA, NY 14853, 30 September 2016 (2016-09-30), XP081360779, DOI: 10.1038/ S41467-017-01905-6**
• **BOTER J M ET AL: "A sparse spin qubit array with integrated control electronics", 2019 IEEE INTERNATIONAL ELECTRON DEVICES MEETING (IEDM), IEEE, 7 December 2019 (2019-12-07), XP033714474, DOI: 10.1109/ IEDM19573.2019.8993570**

EP 4 086 822 B1

## Description

## DOMAINE TECHNIQUE ET ART ANTERIEUR

L'invention concerne le domaine des dispositifs à grilles de commande électrostatique. L'invention s'applique notamment au domaine des dispositifs quantiques, du traitement de l'information quantique et de l'informatique quantique.

L'informatique quantique est basée sur l'utilisation d'un état quantique à deux niveaux mesurables comme vecteur d'information, appelé qubit ou bit quantique ou encore « quantum bit » en anglais, et des lois de la mécanique quantique (superposition, intrication, mesure) afin d'exécuter des algorithmes. Un dispositif quantique à qubits de spin permet de manipuler l'état quantique de ces qubits.

Les qubits de spin peuvent être formés dans du semi-conducteur, avantageusement du silicium. Les technologies semi-conductrices sont étudiées pour la réalisation de qubits en raison de leur haut potentiel d'intégration, à l'image de l'électronique classique. Des électrons ou des trous sont individuellement confinés dans des puits quantiques se trouvant dans un cryostat à des températures cryogéniques (inférieures à 4 K, voire inférieures à 1 K) et réalisés au sein de structures de confinement de tailles nanométriques définies de manière électrostatique et, dans le cas du silicium, d'architecture proche de celle des MOSFETs. Ces structures de confinement correspondent à des boîtes quantiques, également appelées « quantum dots » en anglais. Une boîte quantique se comporte comme un puits de potentiel confinant une ou plusieurs charges élémentaires (électrons ou trous) dans une région de semi-conducteur.

L'application d'un champ magnétique statique (par exemple compris entre 100 mT et 1 T) permet de lever la dégénérescence de spin des quasi-particules, formant ainsi un système quantique à deux niveaux mesurables, nommés « spin down » et « spin up ». L'état quantique du système quantique est une superposition de ces deux états représentés par la direction d'une flèche au sein d'une sphère, nommée sphère de Bloch. La manipulation (rotation) de ces spins est effectuée à l'aide d'une composante alternative du champ magnétique (de fréquence par exemple comprise entre 1 GHz et plusieurs dizaines de GHz) ou à l'aide d'un champ électrique alternatif aux mêmes fréquences dans le cas d'une interaction spin-orbite suffisante (cas des trous dans du silicium par exemple). La lecture des spins (up ou down) permet d'extraire une partie de l'information quantique selon sa probabilité d'être dans chaque état, déterminée par la superposition quantique.

Pour obtenir de bonnes performances à grand nombre de qubits, les qubits sont préférentiellement agencés sous la forme d'une matrice 2D, avec des barrières de potentiels séparant les qubits. Ces barrières et les puits quantiques sont définis en appliquant localement des potentiels électrostatiques sur les régions de semi-conducteur dans lesquelles les barrières et les puits sont formés. Avec un tel agencement, contrôler individuellement N qubits demande la réalisation d'au moins N grilles de commande électrostatique. Or, cela est problématique lorsque le nombre de qubits devient important, par exemple supérieur à 100.

Pour répondre au problème du nombre de grilles de commande à réaliser, il a été proposé de réaliser ces grilles sous la forme d'un quadrillage agencé parallèlement à la couche de semi-conducteur utilisée pour former les qubits. Des premières grilles comportent des premières portions conductrices agencées en lignes et des deuxièmes grilles comportent des secondes portions conductrices agencées en colonnes. Les premières et deuxièmes portions conductrices sont réalisées dans deux niveaux distincts et séparés l'un de l'autre par une couche diélectrique. Le contrôle individuel de chacun des qubits est possible en contrôlant simultanément les quatre barrières de potentiel se trouvant autour de chaque qubit, via les potentiels électrostatiques appliqués par les quatre grilles formées autour du qubit à contrôler.

Cette architecture en lignes et colonnes des grilles impose le contrôle en parallèle de toutes les barrières tunnel d'une même ligne ou d'une même colonne via l'application d'un unique potentiel électrique sur la portion conductrice formant la grille de contrôle de ces barrières tunnel. Cela suppose que les points de fonctionnement des qubits sont connus et contenus dans une faible plage de polarisation. Or, le désordre engendré notamment par les densités d'états à l'interface entre le semi-conducteur, dans lequel sont formés les barrières de potentiel et les boîtes quantiques, et les diélectriques de grille, mais aussi par les charges présentes dans les diélectriques de grille ou les fluctuations du travail de sortie des grilles, induit des modifications locales du potentiel électrostatique qui empêchent de confiner de la même manière les charges à l'intérieur des boîtes quantiques. Ce désordre stochastique local observé est du même ordre de grandeur que les tensions de confinement et est donc particulièrement gênant car il empêche d'utiliser une large plage de polarisation pour tous les qubits.

Le document J. M. Boter et al., "A sparse spin qubit array with integrated control electronics," 2019 IEEE International Electron Devices Meeting (IEDM), San Francisco, CA, USA, 2019, pp. 31.4.1-31.4.4, décrit une solution proposant, pour prendre en compte la variabilité locale, que chaque qubit possède sa propre unité de génération de tensions de polarisation, ce qui permet de venir localement générer des tensions adaptées à chaque configuration locale du désordre. Cela nécessite par contre d'éloigner les qubits les uns des autres d'une distance de l'ordre de quelques microns. Cette distance étant trop grande pour que les qubits puissent interagir les uns avec les autres, il faut donc ajouter un module de transport à grande distance de l'information quantique pour déplacer les qubits sur un lieu d'interaction lors d'opérations entre deux qubits. Cette solution a plusieurs inconvénients :

- la faisabilité du module de communication à longue distance dans le silicium n'a pas été démontrée,
- la solution proposée impose la réalisation de convertisseurs numérique - analogique et de convertisseurs analogique - numérique sous forme de blocs électroniques locaux entraînant une forte consommation énergétique. Cela impose en outre de faire fonctionner le dispositif à haute température (au-delà de 1K), ce qui a pour contrepartie de dégrader les performances du dispositif,
- le nombre de fils d'interconnexion qui sort de la puce quantique est supérieur à celui de l'architecture en lignes et colonnes des grilles, ce qui entraîne potentiellement une augmentation de la consommation de puissance cryogénique, une augmentation du bruit et une complexification des montages.

Le document M. Veldhorst et al., « Silicon CMOS architecture for a spin-based quantum computer », Nat Commun 8, 1766 (2017), propose, pour corriger la variabilité locale, l'application d'une tension locale sur chaque qubit. Cette tension est appliquée via un transistor relié à une capacité dont l'accès est effectué grâce à un transistor situé au-dessus du plan de qubits, dans les interconnexions. Cette solution est toutefois difficilement réalisable compte tenu des faibles dimensions requises pour la réalisation des transistors. En effet, le pas d'un réseau de qubits est de l'ordre de 100 nm. La solution proposée impose de réaliser, dans les niveaux d'interconnexion, quatre transistors pour chaque qubit, ce qui n'est pas réalisable avec les technologies actuelles.

Des problèmes analogues à ceux exposés ci-dessus pour les dispositifs quantiques se posent également pour d'autres types de dispositifs à grille de commande électrostatique.

## EXPOSÉ DE L'INVENTION

Un but de la présente invention est de proposer un dispositif à grilles de commande électrostatique dans lequel la variabilité locale de potentiel électrostatique est compensée, et n'ayant pas les inconvénients des dispositifs de l'art antérieur précédemment décrits.

Pour cela, la présente invention propose un dispositif comportant au moins :

- une couche de semi-conducteur comprenant des premières régions, des deuxièmes régions agencées telles que chacune des premières régions soit délimitée par deux des deuxièmes régions alignées parallèlement à une première direction et que deux des premières régions voisines alignées parallèlement à la première direction soient délimitées par une des deuxièmes régions, et des troisièmes régions agencées telles que chacune des premières régions soit délimitée par deux des troisièmes régions alignées parallèlement à une deuxième direction différente de la première direction (et non parallèle à la première direction) et que deux des premières régions alignées parallèlement à la deuxième direction soient délimitées par une des troisièmes régions,
- des premières grilles de commande électrostatique comportant des premières portions conductrices s'étendant parallèlement à la deuxième direction, à l'aplomb des deuxièmes régions,
- des deuxièmes grilles de commande électrostatique comportant des deuxièmes portions conductrices s'étendant parallèlement à la première direction, à l'aplomb des troisièmes régions,

dans lequel chaque première grille comporte un élément d'ajustement de tension de commande électrostatique formant des première et deuxième impédances reliées en série l'une à l'autre par leurs premières extrémités, une deuxième extrémité de la première impédance étant couplée électriquement à la première portion conductrice de la première grille et une deuxième extrémité de la deuxième impédance étant couplée électriquement à une troisième portion conductrice configurée pour appliquer un potentiel électrique d'ajustement sur la deuxième extrémité de la deuxième impédance, et dans lequel la valeur d'au moins l'une des première et deuxième impédances est ajustable.

Dans ce dispositif, il est proposé de compenser la variabilité locale, dans chaque première région de la couche de semi-conducteur, grâce à un élément d'ajustement de la tension de commande électrostatique appliquée par chaque première grille. Cet élément d'ajustement permet d'appliquer localement un potentiel électrique d'ajustement, ce qui permet de commander de manière électrostatique chacune des deuxièmes régions de la couche de semi-conducteur en tenant compte de la variabilité locale.

Dans le dispositif exposé ci-dessus, les premières portions conductrices sont disposées à l'aplomb des deuxièmes régions. Autrement dit, en considérant des projections des premières portions conductrices et des deuxièmes régions dans un plan parallèle à la face avant de la couche de semi-conducteur et qui passe par cette face avant, au moins une partie de ces projections se superposent. Il est en de même pour les deuxièmes portions conductrices qui sont disposées à l'aplomb des troisièmes régions.

Il est également proposé un dispositif quantique comportant au moins :

- une matrice de qubits réalisés dans une couche de semi-conducteur et agencés en lignes et colonnes, chaque qubit comprenant au moins une boîte quantique,
- des premières barrières de potentiel agencées telles que chaque boîte quantique soit délimitée par deux premières barrières de potentiel alignées parallèlement aux colonnes de qubits et que deux boîtes quantiques voisines d'une même colonne soient délimitées par une première barrière de potentiel, et dont les niveaux d'énergie potentielle sont contrôlés par des premières grilles de commande électrostatique comportant des premières portions conductrices s'étendant parallèlement aux lignes de qubits,

- des deuxièmes barrières de potentiel agencées telles que chaque boîte quantique soit délimitée par deux deuxièmes barrières de potentiel alignées parallèlement aux lignes de qubits et que deux boîtes quantiques voisines d'une même ligne de qubits soient délimitées par une deuxième barrière de potentiel, et dont les niveaux d'énergie potentielle sont contrôlés par des deuxièmes grilles de commande électrostatique comportant des deuxièmes portions conductrices s'étendant parallèlement aux colonnes de qubits,

dans lequel chaque première grille comporte un élément d'ajustement de tension de commande électrostatique formant des première et deuxième impédances reliées en série l'une à l'autre par leurs premières extrémités, une deuxième extrémité de la première impédance étant couplée électriquement à la première portion conductrice de la première grille et une deuxième extrémité de la deuxième impédance étant couplée électriquement à une troisième portion conductrice configurée pour appliquer un potentiel électrique d'ajustement sur la deuxième extrémité de la deuxième impédance, et dans lequel la valeur d'au moins l'une des première et deuxième impédances est ajustable.

Dans tout le document, les termes « ligne » et « colonne » ont été choisis et associés de manière arbitraire aux premières et deuxièmes barrières de potentiel ainsi qu'aux portions conductrices des premières et deuxièmes grilles. Dans un plan, le terme « ligne » est généralement associé à une disposition horizontale et le terme « colonne » est généralement associé à une disposition verticale. Ces termes ne doivent toutefois pas être interprétés uniquement selon cette disposition, mais comme désignant, dans un plan, deux orientations différentes, par exemple sensiblement perpendiculaires l'une par rapport à l'autre. Par exemple, le terme « ligne » peut être associé, dans un plan, à une disposition verticale, et le terme « colonne » peut être associé à une disposition horizontale.

Dans tout le document, les termes « conductrice » et « conducteur » doivent être interprétés comme signifiant « électriquement conductrice » et « électriquement conducteur ».

Les troisièmes portions conductrices peuvent s'étendre parallèlement à la première direction.

En considérant le dispositif exposé ci-dessus, les éléments d'ajustement de tension de commande électrostatique des premières grilles contrôlant les niveaux d'énergie potentielle de premières barrières de potentiel délimitant les boîtes quantiques d'une même colonne de qubits peuvent comporter une troisième portion conductrice commune à ces éléments et s'étendant parallèlement aux colonnes de qubits.

Le dispositif peut comporter en outre des premières portions diélectriques chacune disposée entre l'une des troisièmes portions conductrices et l'une des deuxièmes portions conductrices, chaque deuxième portion conductrice pouvant être disposée entre la couche de semi-conducteur et l'une des premières portions diélectriques.

Le dispositif peut comporter en outre des deuxièmes portions diélectriques chacune disposée entre l'une des troisièmes portions conductrices et les premières portions conductrices.

L'élément d'ajustement de tension de commande électrostatique de chaque première grille peut comporter un élément mémoire formant l'une des première et deuxième impédances dont la valeur est ajustable.

Dans ce cas, dans chaque première grille, l'élément mémoire peut être directement en contact avec la troisième portion conductrice ou la première portion conductrice.

L'élément d'ajustement de tension de commande électrostatique de chaque première grille peut comporter une quatrième portion conductrice comprenant une première extrémité couplée électriquement à l'élément mémoire et :

- une deuxième extrémité couplée électriquement à la première portion conductrice de ladite première grille lorsque l'élément mémoire est directement en contact avec la troisième portion conductrice, et formant l'autre des première et deuxième impédances, ou
- une deuxième extrémité couplée électriquement à la troisième portion conductrice de ladite première grille lorsque l'élément mémoire est directement en contact avec la première portion conductrice, et formant l'autre des première et deuxième impédances.

Dans la configuration ci-dessus, l'autre des première et deuxième impédances est formée à l'interface entre la quatrième portion conductrice et la première ou troisième portion conductrice. La valeur fixe de cette autre des première et deuxième impédances peut être ajustée par traitement de surface ou dépôt de diélectrique.

Les premières et deuxièmes grilles peuvent comporter des diélectriques de grille formés par une même couche de diélectrique de grille disposée entre les deuxièmes portions conductrices et la couche de semi-conducteur et entre les quatrièmes portions conductrices et la couche de semi-conducteur.

Les éléments mémoire peuvent être des mémoires non volatiles de type OxRAM ou FeRAM ou PCRAM.

Les premières régions peuvent être agencées en lignes et colonnes, et la première direction peut être perpendiculaire à la deuxième direction.

Dans une configuration particulière :

- le dispositif correspond à un dispositif quantique,
- les premières régions forment des boîtes quantiques,
- les deuxièmes régions forment des premières barrières de potentiel, et
- les troisièmes régions forment des deuxièmes barrières de potentiel.

Il est également proposé un procédé de réalisation d'un dispositif, comprenant au moins la mise en œuvre des étapes suivantes à partir d'une couche de semi-conducteur comprenant des premières régions, des deuxièmes régions agencées telles que chacune des premières régions soit délimitée par deux des deuxièmes régions alignées parallèlement à une première direction et que deux des premières régions voisines alignées parallèlement à la première direction soient délimitées par une des deuxièmes régions, et des troisièmes régions agencées telles que chacune des premières régions soit délimitée par deux des troisièmes régions alignées parallèlement à une deuxième direction différente de la première direction et que deux des premières régions alignées parallèlement à la deuxième direction soient délimitées par une des troisièmes régions :

- réalisation, sur la couche de semi-conducteur, de premières grilles de commande électrostatique comportant des premières portions conductrices s'étendant parallèlement à la deuxième direction, à l'aplomb des deuxièmes régions,
- réalisation, sur la couche de semi-conducteur, de deuxièmes grilles de commande électrostatique comportant des deuxièmes portions conductrices s'étendant parallèlement à la première direction, à l'aplomb des troisièmes régions,

dans lequel chaque première grille comporte un élément d'ajustement de tension de commande électrostatique formant des première et deuxième impédances reliées en série l'une à l'autre par leurs premières extrémités, une deuxième extrémité de la première impédance étant couplée électriquement à la première portion conductrice de la première grille et une deuxième extrémité de la deuxième impédance étant couplée électriquement à une troisième portion conductrice, et dans lequel la valeur d'au moins l'une des première et deuxième impédances est ajustable.

Il est également proposé un procédé de réalisation d'un dispositif quantique, comprenant au moins la mise en œuvre des étapes suivantes :

- réalisation, dans une couche de semi-conducteur, d'une matrice de qubits agencés en lignes et colonnes, chaque qubit comprenant au moins une boîte quantique,
- réalisation de premières barrières de potentiel agencées telles que chaque boîte quantique soit délimitée par deux premières barrières de potentiel alignées parallèlement aux colonnes de qubits et que deux boîtes quantiques voisines d'une même colonne soient délimitées par une première barrière de potentiel, et dont les niveaux d'énergie potentielle sont contrôlés par des premières grilles de commande électrostatique comportant des première portions conductrices s'étendant parallèlement aux lignes de qubits,
- réalisation de deuxièmes barrières de potentiel agencées telles que chaque boîte quantique soit délimitée par deux deuxièmes barrières de potentiel alignées parallèlement aux lignes de qubits et que deux boîtes quantiques voisines d'une même ligne soient délimitées par une deuxième barrière de potentiel, et dont les niveaux d'énergie potentielle sont contrôlés par des deuxièmes grilles de commande électrostatique comportant des deuxièmes portions conductrices s'étendant parallèlement aux colonnes de qubits,

dans lequel chaque première grille comporte un élément d'ajustement de tension de commande électrostatique formant des première et deuxième impédances reliées en série l'une à l'autre par leurs premières extrémités, une deuxième extrémité de la première impédance étant couplée électriquement à la première portion conductrice de la première grille et une deuxième extrémité de la deuxième impédance étant couplée électriquement à une troisième portion conductrice configurée pour appliquer un potentiel électrique d'ajustement sur la deuxième extrémité de la deuxième impédance, et dans lequel la valeur d'au moins l'une des première et deuxième impédances est ajustable.

Les deuxièmes grilles et les troisièmes portions conductrices peuvent être réalisées en mettant en œuvre les étapes suivantes :

- réalisation, sur la couche de semi-conducteur, d'un empilement de couches comprenant au moins, dans cet ordre, une couche de diélectrique de grille disposée contre la couche de semi-conducteur, une première couche conductrice, une première couche diélectrique, une deuxième couche conductrice et une deuxième couche diélectrique,
- gravure de l'empilement de couches avec arrêt sur la couche de diélectrique de grille, telle que les portions restantes de l'empilement de couches forment les deuxièmes portions conductrices disposées contre la couche de semi-conducteur, des premières portions diélectriques disposées sur les deuxièmes portions conductrices, les troisièmes portions conductrices disposées sur les premières portions diélectriques, et des deuxièmes portions diélectriques disposées sur les troisièmes portions conductrices.

Le procédé peut comporter en outre, après la réalisation des deuxièmes grilles et des troisièmes portions conductrices :

- réalisation d'espaceurs diélectriques contre des faces latérales des portions restantes de l'empilement de couches,
- gravure, par exemple directionnelle latérale ou isotrope latérale, d'une partie des espaceurs diélectriques localisés contre une des faces latérales des portions restantes de l'empilement de couches, formant un accès à une face latérale de chaque troisième portion conductrice,
- dépôt conforme d'une troisième couche conductrice, recouvrant les portions restantes de l'empilement de couches, les espaceurs diélectriques, des parties de la couche de diélectrique de grille non recouvertes par les portions restantes de l'empilement de couches et les espaceurs diélectriques, et ladite face latérale de chaque troisième portion conductrice,
- gravure de la troisième couche conductrice telle que des portions restantes de la troisième couche conductrice s'étendent parallèlement aux lignes de qubits et comportent des parties disposées au-dessus des deuxièmes régions,
- dépôt d'une troisième couche diélectrique sur les portions restantes de la troisième couche conductrice, sur des parties de la couche de diélectrique de grille non recouvertes par les portions restantes de l'empilement de couches, les espaceurs diélectriques et les portions restantes de la troisième couche conductrice, et sur des parties des portions restantes de l'empilement de couches et des espaceurs diélectriques non recouvertes par les portions restantes de la troisième couche conductrice,
- planarisation de la troisième couche diélectrique et des portions restantes de la troisième couche conductrice avec arrêt sur les deuxièmes portions diélectriques, réalisant des troisièmes portions diélectriques et des quatrièmes portions conductrices formant l'autre des première et deuxième impédances.

Dans un premier mode de réalisation, le procédé peut comporter en outre, après la planarisation de la troisième couche diélectrique et des portions restantes de la troisième couche conductrice :

- retrait d'une partie des quatrièmes portions conductrices, formant des cavités dont une partie des parois latérales est formée par ladite face latérale de chaque troisième portion conductrice,
- réalisation, dans les cavités, d'éléments mémoire faisant chacun partie de l'élément d'ajustement de tension de commande électrostatique de l'une des premières grilles et couplé électriquement à une première extrémité de la quatrième portion conductrice dudit élément d'ajustement de tension de commande électrostatique, et de quatrièmes portions diélectriques disposées sur les éléments mémoire,
- réalisation des premières portions conductrices telles qu'elles soient en contact avec des deuxièmes extrémités des quatrièmes portions conductrices.

Dans un deuxième mode de réalisation, le procédé peut comporter en outre, après la planarisation de la troisième couche diélectrique et des portions restantes de la troisième couche conductrice :

- retrait d'une partie des quatrièmes portions conductrices, formant des cavités dont une partie des parois latérales est formée par ladite face latérale de chaque troisième portion conductrice,
- dépôt de quatrièmes portions diélectriques dans les cavités,
- réalisation d'éléments mémoire faisant chacun partie de l'élément d'ajustement de tension de commande électrostatique de l'une des premières grilles et couplé électriquement à une première extrémité de la quatrième portion conductrice dudit élément d'ajustement de tension de commande électrostatique,
- réalisation des premières portions conductrices telles qu'elles soient en contact avec les éléments mémoire.

Il est également proposé un procédé de commande d'un dispositif tel qu'exposé précédemment, dans lequel :

- le dispositif forme un dispositif quantique,
- les premières régions forment des boîtes quantiques,
- les deuxièmes régions forment des premières barrières de potentiel,
- les troisièmes régions forment des deuxièmes barrières de potentiel,

et dans lequel la valeur de ladite au moins des première et deuxième impédances est ajustée et des potentiels électriques sont appliqués sur les premières et deuxièmes grilles pour commander les boîtes quantiques.

De manière générale, dans tout le document, le terme « couche » doit être compris comme désignant soit une unique couche de matériau, soit un empilement de plusieurs couches distinctes de matériaux.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

La figure 1 représente de manière schématique une partie d'un dispositif selon l'invention.

Les figures 2 et 3 représentent schématiquement le principe de fonctionnement d'une première grille de commande électrostatique d'un dispositif selon des premier et deuxième modes de réalisation.

Les figures 4 et 5 représentent schématiquement deux exemples de réalisation de la première grille de commande électrostatique d'un dispositif selon les premier et deuxième modes de réalisation.

Les figures 6 à 13 représentent schématiquement des étapes d'un procédé de réalisation d'un dispositif selon le premier mode de réalisation.

Les figures 14 et 15 représentent schématiquement une partie des étapes d'un procédé de réalisation d'un dispositif selon le deuxième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

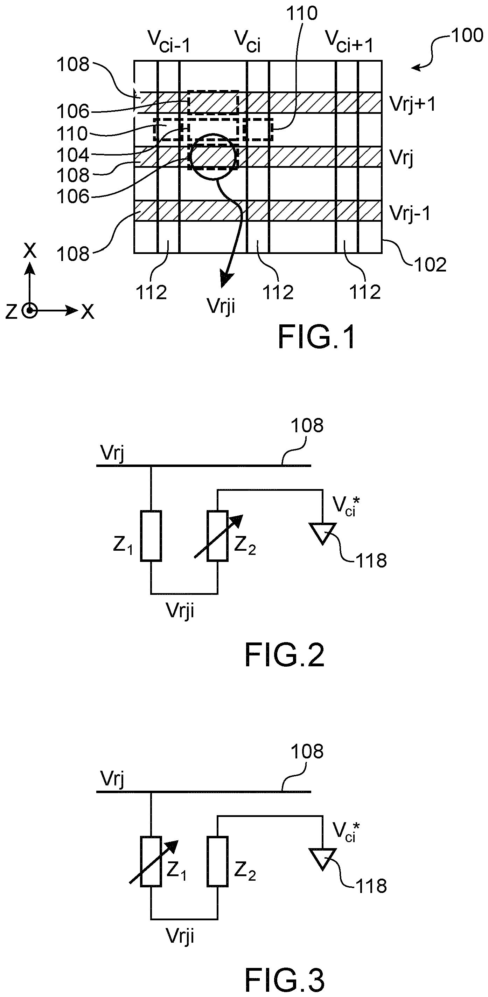

Un dispositif 100 comportant des éléments de compensation de la variabilité locale de potentiel électrostatique est décrit ci-dessous en lien avec la figure 1. Dans l'exemple de réalisation décrit ici, le dispositif 100 correspond à un dispositif quantique à matrice de qubits.

Le dispositif 100 comporte une couche, ou substrat, de semi-conducteur 102 comprenant des premières régions 104, des deuxièmes régions 106 et des troisièmes régions 110. Les deuxièmes régions 106 sont agencées telles que chacune des premières régions 104 soit délimitée par deux des deuxièmes régions 106 alignées parallèlement à une première direction et que deux des premières régions voisines 104 alignées parallèlement à la première direction soient délimitées par une des deuxièmes régions 106. Les troisièmes régions 110 sont agencées telles que chacune des premières régions 104 soit délimitée par deux des troisièmes régions 110 alignées parallèlement à une deuxième direction différente de la première direction et que deux des premières régions 104 alignées parallèlement à la deuxième direction soient délimitées par une des troisièmes régions 110.

La couche 102 comporte par exemple du silicium, du germanium ou du SiGe. D'autres semi-conducteurs peuvent être utilisés. En variante, la couche 102 peut correspondre à un empilement de plusieurs couches comprenant chacune du silicium et/ou du germanium, ou d'autres matériaux semi-conducteurs. L'épaisseur de la couche 102 peut être comprise entre 5 nm, par exemple lorsque la couche 2 correspond à une couche superficielle d'un substrat SOI, et 775 $\mu$m, par exemple lorsque la couche 102 correspond à un substrat bulk ou à une hétérostructure.

Dans l'exemple de réalisation décrit ici, une matrice de qubits est réalisée dans la couche de semi-conducteur 102, et agencés en lignes (parallèles à l'axe X sur l'exemple de la figure 1) et colonnes (parallèles à l'axe Y sur l'exemple de la figure 1). Les lignes sont parallèles à la deuxième direction, et les colonnes sont parallèles à la première direction. Le nombre de lignes et/ou le nombre de colonnes de qubits de cette matrice peut être compris entre 3 et 10000.

Chaque première région 104 de la couche 102 forme, dans l'exemple de réalisation décrit, au moins une boîte quantique. Sur la figure 1, une des premières régions 104 est représentée symboliquement par des traits pointillés.

Les deuxièmes régions 106 de la couche 102 forment, dans l'exemple de réalisation décrit, des premières barrières de potentiel. Ces premières barrières sont agencées telles que chaque boîte quantique soit délimitée par deux des premières barrières alignées parallèlement aux colonnes de qubits et que deux boîtes quantiques voisines d'une même colonne de qubits soient délimitées par une des premières barrières.

Sur la figure 1, deux deuxièmes régions 106 sont représentées symboliquement par des traits pointillés.

Les niveaux d'énergie potentielle des deuxièmes régions 106 sont contrôlés par des premières grilles de commande électrostatique comportant notamment des premières portions conductrices 108 s'étendant parallèlement à la deuxième direction, c'est-à-dire parallèlement aux lignes de qubits dans l'exemple de réalisation décrit. Sur la figure 1, trois premières portions conductrices 108 sont représentées. Les premières portions conductrices 108 ont par exemple chacune une épaisseur (dimension parallèle à l'axe Z représenté sur la figure 1) comprise entre 5 nm et 200 nm et une largeur (dimension parallèle à l'axe Y sur la figure 1) comprise entre 10 nm et 50 nm. Les premières portions conductrices 108 sont par exemple réalisées avec un pas compris entre 30 nm et 120 nm. Les premières portions conductrices 108 sont disposées à l'aplomb des deuxièmes régions 106.

Les troisièmes régions 110 de la couche 102 forment, dans l'exemple de réalisation décrit, des deuxièmes barrières de potentiel. Ces deuxièmes barrières sont agencées telles que chaque boîte quantique soit délimitée par deux des deuxièmes barrières alignées parallèlement aux lignes de qubits et que deux boîtes quantiques voisines d'une même ligne de qubits soient délimitées par une des deuxièmes barrières.

Sur la figure 1, deux troisièmes régions 110 sont représentées symboliquement par des traits pointillés.

Les niveaux d'énergie potentielle des troisièmes régions 110 sont contrôlés par des deuxièmes grilles de commande électrostatique comportant notamment des deuxièmes portions conductrices 112 s'étendant parallèlement à la première direction, c'est-à-dire parallèlement aux colonnes de qubits dans l'exemple de réalisation décrit ici. Sur la figure 1, trois deuxièmes portions conductrices 112 sont représentées. Les deuxièmes portions conductrices 112 ont par exemple chacune une épaisseur (dimension parallèle à l'axe Z représenté sur la figure 1) comprise entre 5 nm et 200 nm et une largeur (dimension parallèle à l'axe X sur la figure 1) comprise entre 10 nm et 50 nm. Les deuxièmes portions conductrices 112 sont par exemple réalisées avec un pas compris entre 30 nm et 120 nm. Selon un exemple de réalisation, chacune des deuxièmes portions conductrices 112 comporte un empilement d'une portion de métal, avantageusement supraconducteur, tel que du TiN ou du NbN, d'épaisseur comprise entre 1 nm et 50 nm, avantageusement comprise entre 2 nm et 5 nm, et d'une portion de polysilicium comprise entre 2 nm et 50 nm, avantageusement comprise entre 5 nm et 10 nm. Les deuxièmes portions conductrices 112 sont disposées à l'aplomb des troisièmes régions 110.

Les emplacements et les dimensions des deuxièmes et troisièmes régions 106, 110 sont déterminés par les emplacements et les dimensions des premières et deuxièmes grilles de commande électrostatique. De plus, les emplacements et les dimensions des premières régions 104 sont déterminés par les emplacements et les dimensions des deuxièmes et troisièmes 106, 110.

Bien que cela ne soit pas visible sur la figure 1, les premières portions conductrices 108 sont réalisées dans un niveau distinct et isolé électriquement de celui dans lequel les deuxièmes portions conductrices 112 sont réalisées.

Des potentiels électriques distincts sont appliqués sur chacune des premières et deuxièmes portions conductrices 108, 112 afin de commander de manière électrostatique chacune des premières et deuxièmes barrières formées par les deuxièmes et troisièmes régions 106, 110.

Afin de pouvoir corriger la variabilité locale de potentiel électrostatique au niveau de chaque qubit de la matrice, chaque première grille comporte un élément d'ajustement de tension de commande électrostatique permettant d'ajuster le potentiel commandant de manière électrostatique chacune des premières barrières 106.

La figure 2 représente schématiquement le principe de fonctionnement d'une des premières grilles du dispositif 100 selon un premier mode de réalisation.

Dans le dispositif 100, un potentiel électrique constant est appliqué sur chaque première portion conductrice 108. Ce potentiel est le même pour toutes les premières grilles de la ligne qui comportent cette première portion conductrice 108. Sur l'exemple de la figure 2, ce potentiel électrique est appelé Vrj. Grâce à l'élément d'ajustement de tension de commande électrostatique présent dans chaque première grille, la valeur de ce potentiel électrique est adaptée localement au niveau de chacune des premières grilles afin que la valeur du potentiel électrique commandant de manière électrostatique le niveau d'énergie potentielle dans la deuxième région 106 correspondante corrige la variabilité locale dans cette région.

Sur l'exemple de la figure 2, cette adaptation de Vrj est réalisée par un élément formant des première et deuxième impédances Z1 et Z2 reliées en série l'une à l'autre au niveau de leurs premières extrémités. Le potentiel Vrj est appliqué sur la deuxième extrémité de la première impédance Z1. Un potentiel électrique Vci* est appliqué sur la deuxième extrémité de la deuxième impédance Z2 depuis une troisième portion conductrice 118. Ce potentiel électrique Vci* est le même pour toutes les premières grilles alignées selon la première direction, c'est-à-dire se trouvant par exemple sur une même colonne. Ce potentiel électrique Vci* a un double rôle : il sert dans un premier temps à programmer la valeur de l'élément mémoire, et dans un second temps, il participe à la définition du potentiel Vrji défini ci-dessous. Il pourra avantageusement être polarisé à la masse dans ce second temps. Le potentiel électrique adapté commandant de manière électrostatique le niveau d'énergie potentielle de la première barrière 106 correspond au potentiel appelé « Vrji » obtenu aux premières extrémités des première et deuxième impédances Z1 et Z2 et qui est égal à :

$$Vr_{ji} = \frac{Z_2}{(Z_1 + Z_2)}\left(Vr_j - Vc_i^*\right)$$

Dans le premier mode de réalisation représenté sur la figure 2, la valeur de la deuxième impédance Z2 est ajustable et celle de la première impédance Z1 est constante.

La figure 3 représente schématiquement le principe de fonctionnement d'une des premières grilles du dispositif 100 selon un deuxième mode de réalisation. Ce fonctionnement est similaire à celui décrit précédemment en lien avec la figure 2, excepté que la valeur de la première impédance Z1 est ajustable et celle de la deuxième impédance Z2 est constante.

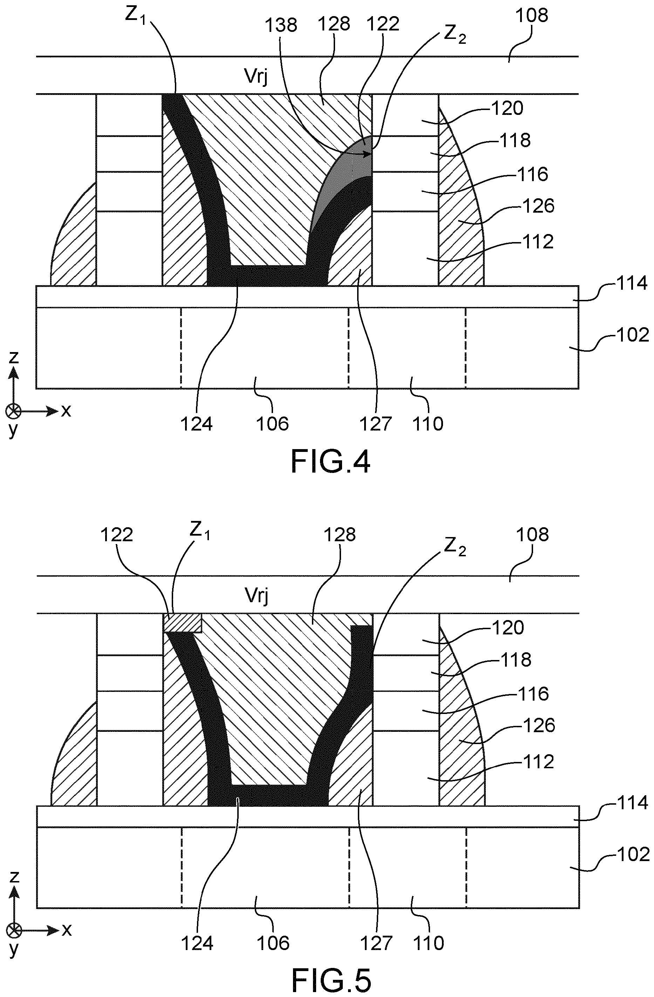

La figure 4 représente schématiquement un exemple de réalisation de l'une des premières grilles du dispositif 100 selon le premier mode de réalisation.

Une couche de diélectrique de grille 114 est disposée sur la couche de semi-conducteur 102. La couche de diélectrique de grille 114 comporte par exem-

ple du $SiO_2$ et a par exemple une épaisseur comprise entre 2 nm et 20 nm. Cette couche de diélectrique de grille 114 sert à former les diélectriques de grilles des premières et deuxièmes grilles, et peut recouvrir toute la surface de la couche de semi-conducteur 102. En variante, cette couche 114 peut comporter un empilement de semi-conducteurs destinés à former une barrière de potentiel entre les couches conductrices formées sur la couche 114 et la couche de semi-conducteur 102 dans laquelle sont formés les boites quantiques. Cet empilement de semi-conducteurs peut contenir des couches de SiGe d'une épaisseur comprise entre 5 nm et 50 nm avec des % de Ge compris entre 10 % et 50 %.

Les deuxièmes portions conductrices 112 sont disposées sur cette couche de diélectrique de grille 114. Sur le schéma de la figure 4, les deuxièmes portions conductrices 112 s'étendent parallèlement à l'axe Y (elles comportent une plus grande dimension parallèle à l'axe Y), c'est-à-dire ici parallèlement aux colonnes de qubits du dispositif 100.

Des premières portions diélectriques 116 sont disposées sur les deuxièmes portions conductrices 112. Les premières portions diélectriques 116 comportent par exemple du $SiO_2$. L'épaisseur (dimension parallèle à l'axe Z) de chacune des premières portions diélectriques est par exemple comprise entre 5 nm et 50 nm, et avantageusement comprise entre 5 nm et 15 nm.

Les troisièmes portions conductrices 118 sont disposées sur les premières portions diélectriques 116 qui assurent l'isolation électrique entre les deuxièmes et troisièmes portions conductrices 112, 118. Ces troisièmes portions conductrices 118 ont par exemple des matériaux et des dimensions similaires aux deuxièmes portions conductrices 112.

Des deuxièmes portions diélectriques 120 sont disposées sur les troisièmes portions conductrices 118. Les premières portions conductrices 108 reposent en partie sur les deuxièmes portions diélectriques 120 qui assurent ainsi une isolation électrique entre les premières et troisièmes portions conductrices 108, 118. Ces deuxièmes portions diélectriques 120 comportent par exemple du $SiO_2$, du SiN, ou de l'$Al_2O_3$, et ont par exemple une épaisseur (dimension parallèle à l'axe Z) comprise entre 10 nm et 100 nm, et avantageusement comprise entre 5 et 30nm.

Dans l'exemple de réalisation décrit ici, les premières et deuxièmes portions diélectriques 116, 120 et les troisièmes portions conductrices 118 ont, dans le plan (X, Y), une forme et des dimensions similaires à celles des deuxièmes portions conductrices 112. Ainsi, sur le schéma de la figure 4, les premières et deuxièmes portions diélectriques 116, 120 et les deuxièmes et troisièmes portions conductrices 112, 118 s'étendent parallèlement à l'axe Y, c'est-à-dire ici parallèlement à la première direction ou, dans l'exemple de réalisation décrit, aux colonnes de qubits du dispositif 100.

Les éléments d'ajustement de tension de commande électrostatique des premières grilles contrôlant les niveaux d'énergie potentielle dans les deuxièmes régions 106 délimitant des premières régions 104 alignées parallèles à la première direction, c'est-à-dire d'une même colonne de qubits dans l'exemple décrit ici, comportent l'une des troisièmes portions conductrices 118 qui s'étend parallèlement aux colonnes de qubits et qui est commune aux premières grilles d'une même colonne. Ces troisièmes portions conductrices 118 servent à appliquer le potentiel électrique Vci* destiné notamment à compenser la variabilité locale au niveau du qubit commandé par chacune des premières grilles. La valeur de ce potentiel électrique sera le même pour toutes les premières grilles qui partagent une même troisième portion conductrice 118.

L'élément d'ajustement de tension de chacune des premières grilles comporte également un élément mémoire 122. Dans le premier mode de réalisation décrit ici, l'élément mémoire 122 forme la deuxième impédance Z2 dont la valeur est ajustable. Cet élément mémoire 122 est couplé électriquement à la troisième portion conductrice 118 au niveau d'une des faces latérales 138 (faces parallèles au plan (Y, Z) sur l'exemple de la figure 4) de la troisième portion conductrice 118. L'élément mémoire 122 est directement en contact avec la troisième portion conductrice 118.

Selon un exemple de réalisation particulier, l'élément mémoire 122 peut être une mémoire non volatile résistive de type OxRAM (mémoire résistive à base d'oxyde), correspondant dans ce cas à une résistance variable, ou de type FeRAM (mémoire à couche ferroélectrique) ou PCRAM (mémoire à matériau à changement de phase), correspondant dans ce cas à une capacité variable. L'élément mémoire 122 correspond par exemple à une portion de $HfO_2$ ou de $HfZrO_2$ ou de tout autre matériau diélectrique possédant des effets mémoire, recouverte d'une électrode métallique comprenant par exemple du Ti.

L'élément d'ajustement de tension de chacune des premières grilles comporte également une quatrième portion conductrice 124. Dans l'exemple de réalisation de la figure 4, la première impédance Z1 dont la valeur est constante correspond à la résistance de contact entre la quatrième portion conductrice 124 et la première portion conductrice 108. La quatrième portion conductrice 124, en contact avec l'élément mémoire 122, forme une deuxième électrode métallique en contact avec la portion de matériau diélectrique à effet mémoire de l'élément mémoire 122. La quatrième portion conductrice 124 comporte avantageusement un matériau supraconducteur tel que du TiN, du NbN ou du Nb ou du Ti ou un empilement de plusieurs de ces matériaux (et avantageusement avec du Ti qui fournit des lacunes d'oxygène ultérieurement utilisées pour l'effet mémoire de l'élément mémoire 122). L'utilisation d'un matériau supraconducteur pour former la quatrième portion conductrice 124 permet de garantir une constance de la valeur du potentiel qui permettra de commander les premières barrières 106. La quatrième portion conductrice 124 peut être issue d'une couche de matériau déposée de manière conforme avec une épaisseur comprise entre 2 nm et 20 nm, et avantageusement égale à 5 nm.

Outre ces éléments, le dispositif 100 comporte des espaceurs diélectriques 126, 127 disposés contre des faces latérales des empilements formés des deuxièmes et troisièmes portions conductrices 112, 118 et des premières et deuxièmes portions diélectriques 116, 120. Les espaceurs diélectriques 126, 127 comportent par exemple du SiN et/ou du $SiO_2$ et/ou un matériau à faible permittivité diélectrique tel que du SiCO ou du SiCBN. Pour chacun de ces empilements, un des espaceurs diélectriques 127 est partiellement gravé tel qu'une des faces latérales 138 de chaque troisième portion conductrice 118 ne soit pas recouverte par cet espaceur 127 et soit en contact électriquement avec l'un des éléments mémoire 122.

Le dispositif 100 comporte également des troisièmes portions diélectriques 128 qui assurent notamment l'isolation électrique entre les éléments mémoire 122 et les premières portions conductrices 108. Les troisièmes portions diélectriques 128 comportent par exemple du $SiO_2$.

Outre les première et deuxième impédances Z1 et Z2 formées dans cette structure, un chemin de fuite d'impédance Z3 peut se former entre l'extrémité de la quatrième portion conductrice 124 couplée à l'élément mémoire 122 et la troisième portion conductrice 118. Afin d'avoir la valeur de l'impédance Z3 qui soit beaucoup plus grande que celles des impédances Z1 et Z2, pour éviter des dysfonctionnements du dispositif 100, la quatrième portion conductrice 124 est réalisée de manière à ce qu'elle soit éloignée et bien isolée électriquement de la troisième portion conductrice 118, comme cela est décrit plus loin en lien avec le procédé de réalisation du dispositif 100.

La figure 5 représente schématiquement un exemple de réalisation de l'une des premières grilles du dispositif 100 selon le deuxième mode de réalisation.

Chacune des premières grilles du dispositif 100 selon le deuxième mode de réalisation comporte tous les éléments précédemment décrits pour les premières grilles du dispositif 100 selon le premier mode de réalisation. Toutefois, dans ce deuxième mode de réalisation, dans chaque élément d'ajustement de tension des premières grilles, l'élément mémoire 122 n'est pas en contact directement avec la troisième portion conductrice 118 mais avec la première portion conductrice 108. De plus, la quatrième portion conductrice 124 est directement couplée à la troisième portion conductrice 118.

Ainsi, dans ce deuxième mode de réalisation, la valeur de l'impédance Z1, formée par l'élément mémoire 122, est ajustable et celle de l'impédance Z2, formée par la résistance de contact entre les troisième et quatrième portions conductrices 118, 124, est constante.

A titre d'exemple, quel que soit le mode de réalisation du dispositif 100 :

- la valeur du potentiel Vrji peut être comprise entre -1V et 1 V,
- la valeur de l'impédance de valeur variable, formée par l'élément mémoire 122, peut être comprise entre quelques kΩ et quelques GΩ,
- la valeur de l'impédance de valeur constante, formée par la résistance de contact entre la quatrième portion conductrice 124 et la troisième portion conductrice 118 ou la première portion conductrice 108, peut être comprise entre quelques kΩ et quelques MΩ, par exemple entre 5 kΩ et 5 MΩ.

Afin de pouvoir compenser la variabilité locale dans chaque première région 104, il convient de déterminer les valeurs de l'impédance variable ainsi que les valeurs des potentiels Vci* à appliquer. Pour cela, il est par exemple possible de :

- caractériser tout d'abord toutes les premières régions 104 de semi-conducteur via la mise en œuvre de mesures de diagrammes de stabilité réalisées en utilisant les premières et deuxièmes grilles du dispositif 100, dans le but de déterminer quels niveaux de tensions appliqués sur ces grilles permettent d'accéder aux énergies de charge et tensions d'entrée du premier électron, c'est-à-dire permettre une initialisation des qubits avec un électron par boîte quantique dans l'exemple décrit ici. Par ailleurs cette étape de caractérisation peut aussi permettre de déterminer les tensions de polarisation individuelles qui permettront de contrôler chaque qubit,
- programmer individuellement les impédances variables formées par les éléments mémoire 122, via l'application de tensions à ses bornes à travers les premières, troisièmes et quatrièmes portions conductrices 108, 118, 124, pour permettre que chaque potentiel Vrji appliqué localement conduisent à la même configuration du potentiel de commande des deuxièmes et troisièmes régions 106, 110 pour les tensions appliquées Vrj et Vci,
- lors du fonctionnement du dispositif 100, appliquer les niveaux de tensions calculés Vrj, Vci et Vci* permettant d'obtenir la compensation de variabilité locale pour chaque première région 104.

A titre d'exemple, la détermination du régime à un électron de chaque boite quantique peut être obtenue grâce à la mise en place d'un protocole de détections de charge au sein des boîtes quantiques. Pour cela, il est possible d'intégrer des détecteurs de charge (par exemple des transistors à électron unique, ou SET pour « Single Electron Transistor » en anglais) à proximité des qubits. Ces détecteurs fournissent une information sur le nombre de charges confinées dans les boites quantiques environnantes. En mesurant par exemple le courant traversant un SET en même temps que l'on fait varier les tensions appliquées sur les premières et deuxièmes grilles d'une boite quantique à laquelle ce SET est associé, il est possible de remonter aux gammes de tensions pour lesquelles un unique électron est bien confiné dans cette boite quantique. Si cette gamme de tension est incompatible avec celle déterminée pour autre boite quantique partageant ces grilles de contrôle, c'est-à-dire se trouvant sur une même ligne ou colonne, la programmation des impédances variables Z1 et Z2 permettra d'y palier. D'autres techniques sont possibles pour déterminer le nombre de charges contenues dans une boite quantique, par exemple via l'utilisation d'un circuit résonnant (« circuit de réflectométrie ») connecté à une grille de contrôle.

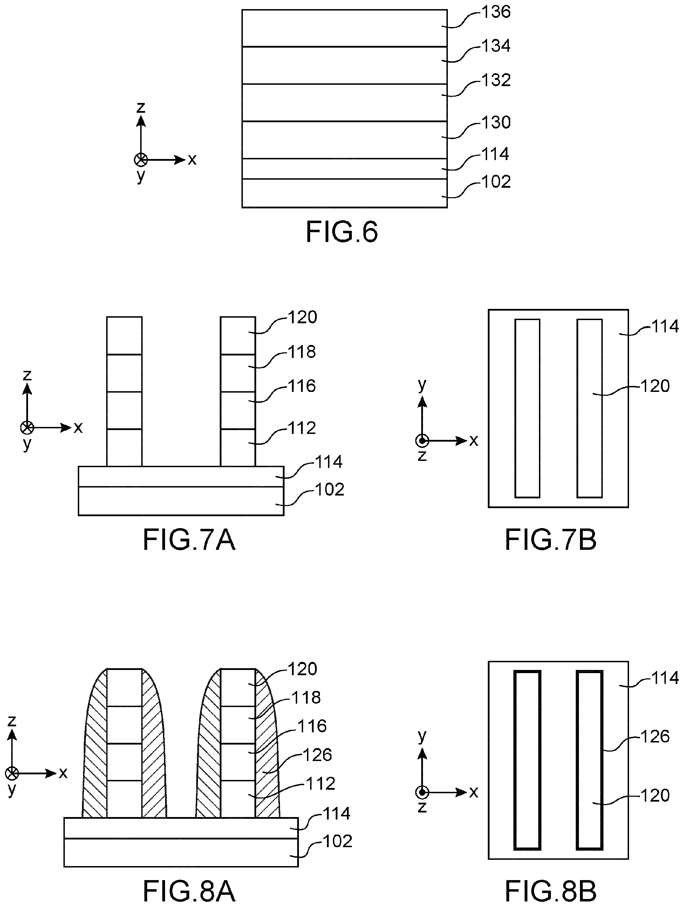

Un procédé de réalisation du dispositif 100 selon le premier mode de réalisation est décrit ci-dessous en lien avec les figures 6 à 13.

Un empilement de couches, destiné à la réalisation de la couche de diélectrique de grille 114, des premières et deuxièmes portions diélectriques 116, 120 et des deuxièmes et troisièmes portions conductrices 112, 118, est réalisé sur la couche 102 (voir figure 6).

La couche de diélectrique de grille 114 est tout d'abord réalisée sur la couche 102, par exemple par oxydation thermique.

Une première couche conductrice 130, formée d'un ou plusieurs matériaux conducteurs empilés, est déposée ensuite sur la couche de diélectrique de grille 114.

Une première couche diélectrique 132 est ensuite réalisée sur la première couche conductrice 130.

Une deuxième couche conductrice 134, formée d'un ou plusieurs matériaux conducteurs empilés, est déposée ensuite sur la première couche diélectrique 132.

Une deuxième couche diélectrique 136 est réalisée sur la deuxième couche conductrice 134. Cette deuxième couche diélectrique 136 est destinée à former les deuxièmes portions diélectriques 120, mais va également servir à la réalisation d'un masque de gravure et servir également de couche d'arrêt pour la mise en œuvre d'une planarisation.

Cet empilement est gravé, en formant tout d'abord un masque de gravure à partir de la deuxième couche diélectrique 136, puis en gravant les autres couches de l'empilement jusqu'à atteindre la couche de diélectrique de grille 114. Les portions restantes de l'empilement forment les premières et deuxièmes portions diélectriques 116, 120 et les deuxièmes et troisièmes portions conductrices 112, 118 (voir figures 7A et 7B, correspondant respectivement à une vue en coupe et une vue de dessus de la structure obtenue à ce stade du procédé).

Les espaceurs diélectriques 126 sont ensuite réalisés par dépôt d'au moins un matériau diélectrique, puis une gravure de ce ou ces matériaux diélectriques afin de ne conserver que des portions de ce ou ces matériaux disposées contre les flancs latéraux des portions 112, 116, 118, 120 (voir figures 8A et 8B).

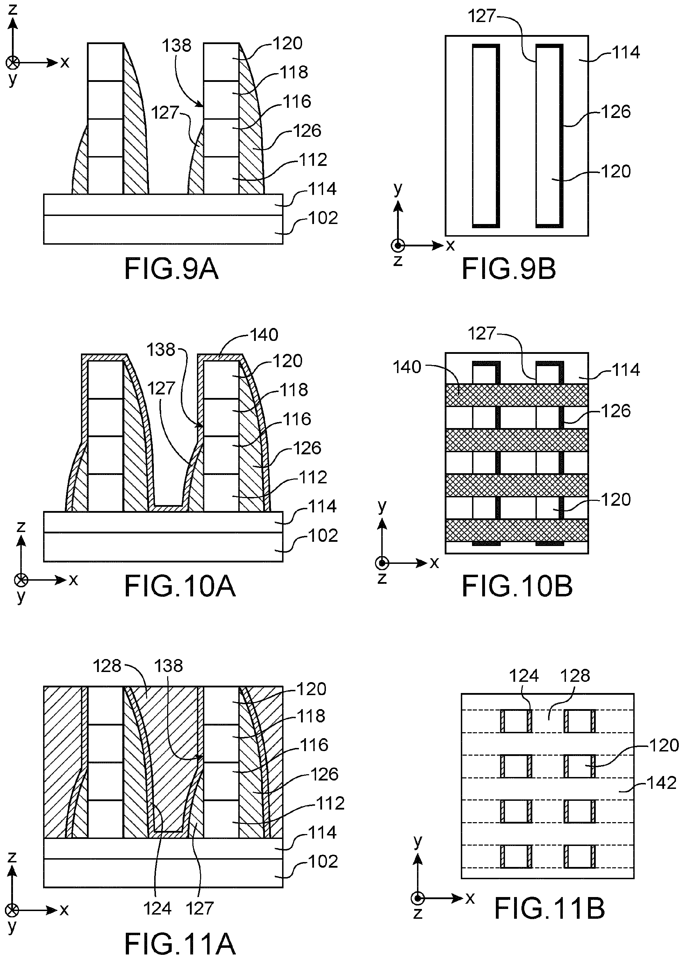

Une gravure, par exemple directionnelle latérale ou isotrope latérale, d'une partie des espaceurs 126 localisés contre une des faces latérales des portions 112, 116, 118, 120 est mise en œuvre, formant un accès à une face latérale 138 de chaque troisième portion conductrice 118. Sur les figures 9A et 9B, les espaceurs gravés sont désignés par la référence 127. Cette gravure peut avantageusement être réalisée de manière auto-alignée en mettant en œuvre une implantation ionique formant, par rapport à une droite perpendiculaire à la face de la couche 114 sur laquelle reposent les espaceurs 126, un angle (appelé couramment « tilt ») non nul, ou par utilisation d'un plasma directionnel, puis en mettant en œuvre une gravure chimique ou ionique réactive. En variante, cette gravure peut être réalisée en mettant en œuvre une photolithographie et une gravure.

Une couche de matériau conducteur, par exemple métallique et comportant avantageusement un matériau supraconducteur, est ensuite déposée de manière conforme, c'est-à-dire en formant une couche d'épaisseur constante sur les parois contre lesquelles cette couche est déposée. Cette couche de matériau conducteur recouvre les portions restantes 112, 116, 118, 120 de l'empilement de couches (et notamment les faces latérales 138 des troisièmes portions conductrices 118), les espaceurs diélectriques 126, 127, ainsi que les parties de la couche de diélectrique de grille 114 non recouvertes par les portions restantes 112, 116, 118, 120 et les espaceurs diélectriques 126, 127. Cette couche de matériau conducteur est destinée à former les quatrièmes portions conductrices 124. Après ce dépôt, cette couche de matériau conducteur est gravée afin que des portions restantes 140 de cette couche s'étendant parallèlement aux lignes de qubits, et ayant des parties disposées au-dessus des régions de la couche 102 dans lesquelles les premières barrières 106 sont destinées à être formée, soient conservées (voir figures 10A et 10B).

Une troisième couche diélectrique 142, comportant par exemple un oxyde tel que du $SiO_2$, est ensuite déposée sur l'ensemble de la structure précédemment réalisée, remplissant les espaces présents entre les empilements des portions 112, 116, 118 et 120 et recouvrant les portions restantes 140 de la couche de matériau conducteur précédemment déposée.

Une planarisation de cette troisième couche diélectrique 142 et des parties des portions restantes 140 se trouvant sur les deuxièmes portions diélectriques 120 est ensuite mise en œuvre, en s'arrêtant sur les deuxièmes portions diélectriques 120. Les parties des portions 140 conservées à l'issue de cette planarisation forment les quatrièmes portions conductrices 124, chacune en contact électriquement avec l'une des troisièmes portions conductrices 118 par la face latérale 138. Des parties restantes de la troisième couche diélectrique 142 correspondent aux troisièmes portions diélectriques 128 (voir figures 11A et 11B).

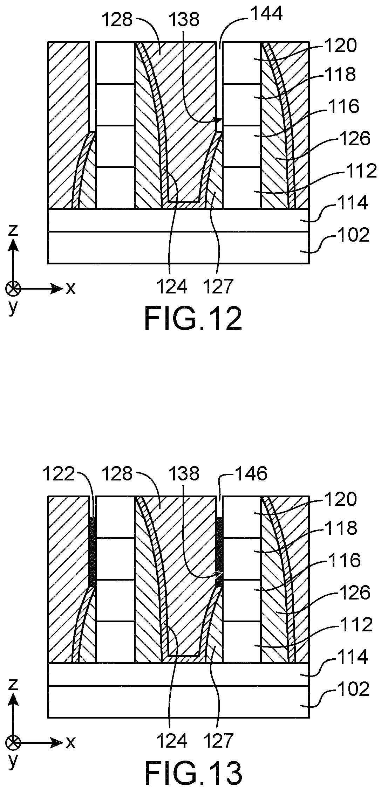

Des parties des quatrièmes portions conductrices 124 sont ensuite retirées par gravure, formant dans la couche de matériau diélectrique 142 des cavités 144 dont une partie des parois latérales est formée par les faces latérales 138 des troisièmes portions conductrices 118. Ces cavités 144 permettant d'accéder aux quatrièmes portions conductrices 124 et aux troisièmes portions conductrices 118 (voir figure 12). Cette gravure est par exemple précédée d'une photolithographie. La gravure mise en œuvre est par exemple de type RIE (gravure ionique réactive) sélective ou une gravure chimique mise en œuvre par exemple avec une solution d'HCl ou de $H_2O_2$ et dont la vitesse de gravure est contrôlée afin de graver ces parties des quatrièmes portions conductrices 124 sans graver les troisièmes portions conductrices 118. Cette gravure est stoppée lorsque les parois de fond des cavités 144 atteignent au moins les premières portions diélectriques 116.

Les éléments mémoire 122 sont ensuite réalisés dans les cavités 144, en déposant par exemple du $HfO_2$, du $HfZrO_2$ ou tout autre matériau diélectrique possédant un effet mémoire, puis une électrode métallique comprenant par exemple du Ti. Les éléments mémoire 122 sont réalisés sans remplir complètement les cavités 144 afin de limiter les fuites avec les futures premières portions conductrices 108 qui seront réalisées par la suite. Pour cela, une distance d'au moins 5 nm entre la face supérieure des éléments mémoire 122 et la face supérieure des deuxièmes portions diélectriques 120 peut par exemple être conservée. Les espaces vides restants au-dessus des éléments mémoire 122 sont remplis par du matériau diélectrique, formant des quatrièmes portions diélectriques 146 disposées sur les éléments mémoire 122 (voir figure 13).

Le dispositif 100 est achevé en réalisant les premières portions conductrices 108, par exemple en mettant en œuvre un dépôt métallique, une lithographie et une gravure, ou par un procédé de dépôt de type damascene. Avant ce dépôt, un traitement de surface peut être mis en œuvre pour définir les valeurs fixes des impédances Z1 qui correspondent, dans ce premier mode de réalisation, aux résistances de contact entre le matériau de quatrièmes portions conductrices 124 et celui des premières portions conductrices 108. Enfin, un ou plusieurs niveaux d'interconnexion de type Back-end sont réalisés pour permettre les connexions aux différents éléments conducteurs du dispositif 100.

Un procédé de réalisation du dispositif 100 selon le deuxième mode de réalisation est décrit ci-dessous.

Les étapes précédemment décrites en lien avec les figures 6 à 12 sont tout d'abord mises en œuvre.

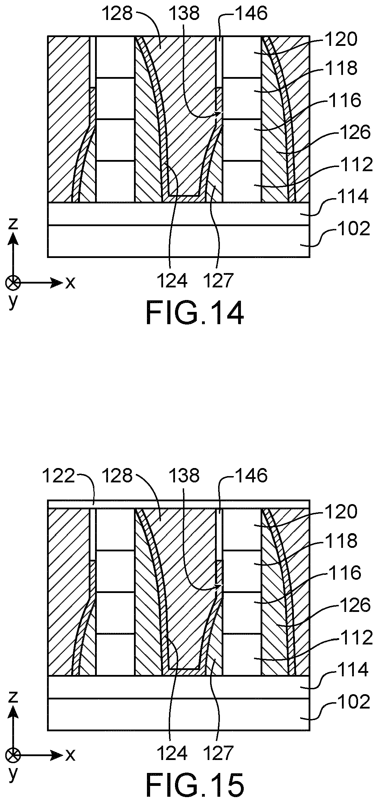

Les cavités 144 sont ensuite remplies par un matériau diélectrique, formant les quatrièmes portions diélectriques 146 (voir figure 14).

Une couche de matériau diélectrique à effet mémoire, par exemple similaire à celui précédemment décrit pour la réalisation des éléments mémoire 122 du dispositif 100 selon le premier mode de réalisation, est ensuite déposée (voir figure 15), puis éventuellement gravée afin de former les éléments mémoire 122 couplés aux quatrièmes portions conductrices 124 pour obtenir une structure telle que précédemment décrite en lien avec la figure 5.

Les premières portions conductrices 108 sont ensuite réalisées telles qu'elles soient en contact avec les éléments mémoire 122. Dans ce deuxième mode de réalisation, les premières portions conductrices 108 peuvent être réalisées sous la forme d'un empilement de plusieurs intégrant notamment une première couche comprenant par exemple du Ti et servant d'électrodes aux éléments mémoire 122.

Le dispositif 100 est achevé comme dans le premier mode de réalisation, en réalisant un ou plusieurs niveaux d'interconnexion de type Back-end permettant les connexions aux différents éléments conducteurs du dispositif 100.

Dans les différents modes de réalisation et exemples précédemment décrits, il est possible que :

- le dispositif 100 correspond à un dispositif quantique,
- les premières régions 104 forment des boîtes quantiques,
- les deuxièmes régions 106 forment des premières barrières de potentiel, et
- les troisièmes régions 110 forment des deuxièmes barrières de potentiel.

En variante, le dispositif 100 peut correspondre à un dispositif de type CMOS, avec dans ce cas l'élément d'ajustement de tension de commande électrostatique servant à moduler la tension de grille des transistors, ou bien le dispositif 100 peut correspondre à un capteur d'image dans lequel les différentes régions de la couche 102 forment des diodes.

## Revendications

1. Dispositif (100) comportant au moins :

- une couche de semi-conducteur (102) comprenant des premières régions (104), des deuxièmes régions (106) agencées telles que chacune des premières régions (104) soit délimitée par deux des deuxièmes régions (106) alignées parallèlement à une première direction et que deux des premières régions voisines (104) alignées parallèlement à la première direction soient délimitées par une des deuxièmes régions (106), et des troisièmes régions (110) agencées telles que chacune des premières régions (104) soit délimitée par deux des troisièmes régions (110) alignées parallèlement à une deuxième direction différente de la première direction et que deux des premières régions (104) alignées parallèlement à la deuxième direction soient délimitées par une des troisièmes régions (110),
- des premières grilles de commande électrostatique comportant des premières portions conductrices (108) s'étendant parallèlement à la deuxième direction, à l'aplomb des deuxièmes régions (106),
- des deuxièmes grilles de commande électrostatique comportant des deuxièmes portions conductrices (112) s'étendant parallèlement à la première direction, à l'aplomb des troisièmes régions (110),

dans lequel chaque première grille comporte un élément d'ajustement de tension de commande électrostatique formant des première et deuxième impédances (Z1, Z2) reliées en série l'une à l'autre par leurs premières extrémités, une deuxième extrémité de la première impédance (Z1) étant couplée électriquement à la première portion conductrice (108) de la première grille et une deuxième extrémité de la deuxième impédance (Z2) étant couplée électriquement à une troisième portion conductrice (118), et dans lequel la valeur d'au moins l'une des première et deuxième impédances (Z1, Z2) est ajustable.

2. Dispositif (100) selon la revendication 1, dans lequel les troisièmes portions conductrice (118) s'étendent parallèlement à la première direction.

3. Dispositif (100) selon la revendication 2, comportant en outre des premières portions diélectriques (116) chacune disposée entre l'une des troisièmes portions conductrices (118) et l'une des deuxièmes portions conductrices (112), chacune des deuxièmes portions conductrices (112) étant disposée entre la couche de semi-conducteur (102) et l'une des premières portions diélectriques (116).

4. Dispositif (100) selon l'une des revendications 2 ou 3, comportant en outre des deuxièmes portions diélectriques (120) chacune disposée entre l'une des troisièmes portions conductrices (118) et les premières portions conductrices (108).

5. Dispositif (100) selon l'une des revendications précédentes, dans lequel l'élément d'ajustement de tension de commande électrostatique de chaque première grille comporte un élément mémoire (122) formant l'une des première et deuxième impédances (Z1, Z2) dont la valeur est ajustable.

6. Dispositif (100) selon la revendication 5, dans lequel, dans chaque première grille, l'élément mémoire (122) est directement en contact avec la troisième portion conductrice (118) ou la première portion conductrice (108).

7. Dispositif (100) selon l'une des revendications 5 ou 6, dans lequel l'élément d'ajustement de tension de commande électrostatique de chaque première grille comporte une quatrième portion conductrice (124) comprenant une première extrémité couplée électriquement à l'élément mémoire (122) et :

- une deuxième extrémité couplée électriquement à la première portion conductrice (108) de ladite première grille lorsque l'élément mémoire (122) est directement en contact avec la troisième portion conductrice (118), et formant l'autre des première et deuxième impédances (Z1, Z2), ou
- une deuxième extrémité couplée électriquement à la troisième portion conductrice (118) de ladite première grille lorsque l'élément mémoire (122) est directement en contact avec la première portion conductrice (108), formant l'autre des première et deuxième impédances (Z1, Z2).

8. Dispositif (100) selon la revendication 7, dans lequel les premières et deuxièmes grilles comportent des diélectriques de grille formés par une même couche de diélectrique de grille (114) disposée entre les deuxièmes portions conductrices (112) et la couche de semi-conducteur (102) et entre les quatrièmes portions conductrices (124) et la couche de semi-conducteur (102).

9. Dispositif (100) selon l'une des revendications 5 à 8, dans lequel les éléments mémoire (122) sont des mémoires non volatiles résistives de type OxRAM ou FeRAM ou PCRAM.

10. Dispositif (100) selon l'une des revendications précédentes, dans lequel les premières régions (104) sont agencées en lignes et colonnes, et dans lequel la première direction est perpendiculaire à la deuxième direction.

11. Procédé de réalisation d'un dispositif (100), comprenant au moins la mise en œuvre des étapes suivantes à partir d'une couche de semi-conducteur (102) comprenant des premières régions (104), des deuxièmes régions (106) agencées telles que chacune des premières régions (104) soit délimitée par deux des deuxièmes régions (106) alignées parallèlement à une première direction et que deux des premières régions voisines (104) alignées parallèlement à la première direction soient délimitées par une des deuxièmes régions (106), et des troisièmes régions (110) agencées telles que chacune des premières régions (104) soit délimitée par deux des troisièmes régions (110) alignées parallèlement à une deuxième direction différente de la première direction et que deux des premières régions (104) alignées parallèlement à la deuxième direction soient délimitées par une des troisièmes régions (110) :

- réalisation, sur la couche de semi-conducteur (102), de premières grilles de commande électrostatique comportant des première portions conductrices (108) s'étendant parallèlement à la deuxième direction, à l'aplomb des deuxièmes régions (106),
- réalisation, sur la couche de semi-conducteur (102), de deuxièmes grilles de commande électrostatique comportant des deuxièmes portions conductrices (112) s'étendant parallèlement à la première direction, à l'aplomb des troisièmes régions (110),

dans lequel chaque première grille comporte un élément d'ajustement de tension de commande électrostatique formant des première et deuxième impédances (Z1, Z2) reliées en série l'une à l'autre par leurs premières extrémités, une deuxième extrémité de la première impédance (Z1) étant couplée électriquement à la première portion conductrice (108) de la première grille et une deuxième extrémité de la deuxième impédance (Z2) étant couplée électriquement à une troisième portion conductrice (118), et dans lequel la valeur d'au moins l'une des première et deuxième impédances (Z1, Z2) est ajustable.

12. Procédé selon la revendication 11, dans lequel les deuxièmes grilles et les troisièmes portions conductrices (118) sont réalisées en mettant en œuvre les étapes suivantes :

- réalisation, sur la couche de semi-conducteur (102), d'un empilement de couches comprenant au moins, dans cet ordre, une couche de diélectrique de grille (114) disposée contre la couche de semi-conducteur (102), une première couche conductrice (130), une première couche diélectrique (132), une deuxième couche conductrice (134) et une deuxième couche diélectrique (136),
- gravure de l'empilement de couches avec arrêt sur la couche de diélectrique de grille (114), telle que les portions restantes de l'empilement de couches forment les deuxièmes portions conductrices (112) disposées contre la couche de semi-conducteur (102), des premières portions diélectriques (116) disposées sur les deuxièmes portions conductrices (112), les troisièmes portions conductrices (118) disposées sur les premières portions diélectriques (116), et des deuxièmes portions diélectriques (120) disposées sur les troisièmes portions conductrices (118).

13. Procédé selon la revendication 12, comportant en outre, après la réalisation des deuxièmes grilles et des troisièmes portions conductrices (118) :

- réalisation d'espaceurs diélectriques (126, 127) contre des faces latérales des portions restantes (112, 116, 118, 120) de l'empilement de couches,
- gravure d'une partie des espaceurs diélectriques (127) localisés contre une des faces latérales des portions restantes (112, 116, 118, 120) de l'empilement de couches, formant un accès à une face latérale (138) de chaque troisième portion conductrice (118),
- dépôt conforme d'une troisième couche conductrice, recouvrant les portions restantes (112, 116, 118, 120) de l'empilement de couches, les espaceurs diélectriques (126, 127), des parties de la couche de diélectrique de grille (114) non recouvertes par les portions restantes (112, 116, 118, 120) de l'empilement de couches et les espaceurs diélectriques (126, 127), et ladite face latérale (138) de chaque troisième portion conductrice (118),
- gravure de la troisième couche conductrice telle que des portions restantes (140) de la troisième couche conductrice s'étendent parallèlement aux lignes de qubits et comportent des parties disposées au-dessus des deuxièmes régions (106),
- dépôt d'une troisième couche diélectrique (142) sur les portions restantes (140) de la troisième couche conductrice, sur des parties de la couche de diélectrique de grille (114) non recouvertes par les portions restantes (112, 116, 118, 120) de l'empilement de couches, les espaceurs diélectriques (126, 127) et les portions restantes (140) de la troisième couche conductrice, et sur des parties des portions restantes (112, 116, 118, 120) de l'empilement de couches et des espaceurs diélectriques (126, 127) non recouvertes par les portions restantes (140) de la troisième couche conductrice,
- planarisation de la troisième couche diélectrique (142) et des portions restantes (140) de la troisième couche conductrice avec arrêt sur les deuxièmes portions diélectriques (120), réalisant des troisièmes portions diélectriques (128) et des quatrièmes portions conductrices (124).

14. Procédé selon la revendication 13, comportant en outre, après la planarisation de la troisième couche diélectrique (142) et des portions restantes (140) de la troisième couche conductrice :

- retrait d'une partie des quatrièmes portions conductrices (124), formant des cavités (144) dont une partie des parois latérales est formée par ladite face latérale (138) de chaque troisième portion conductrice (118),

- réalisation, dans les cavités (144), d'éléments mémoire (122) faisant chacun partie de l'élément d'ajustement de tension de commande électrostatique de l'une des premières grilles et couplé électriquement à une première extrémité de la quatrième portion conductrice (124) dudit élément d'ajustement de tension de commande électrostatique, et de quatrièmes portions diélectriques (146) disposées sur les éléments mémoire (122),

- réalisation des premières portions conductrices (108) telles qu'elles soient en contact avec des deuxièmes extrémités des quatrièmes portions conductrices (124).

15. Procédé selon la revendication 13, comportant en outre, après la planarisation de la troisième couche diélectrique (142) et des portions restantes (140) de la troisième couche conductrice :

- retrait d'une partie des quatrièmes portions conductrices (124), formant des cavités (144) dont une partie des parois latérales est formée par ladite face latérale (138) de chaque troisième portion conductrice (118),

- dépôt de quatrièmes portions diélectriques (146) dans les cavités (144),

- réalisation d'éléments mémoire (122) faisant chacun partie de l'élément d'ajustement de tension de commande électrostatique de l'une des premières grilles et couplé électriquement à une première extrémité de la quatrième portion conductrice (124) dudit élément d'ajustement de tension de commande électrostatique,

- réalisation des premières portions conductrices (108) telles qu'elles soient en contact avec les éléments mémoire (122).

16. Procédé de commande d'un dispositif (100) selon l'une des revendications 1 à 10, dans lequel :

- le dispositif (100) forme un dispositif quantique,
- les premières régions (104) forment des boîtes quantiques,
- les deuxièmes régions (106) forment des premières barrières de potentiel,
- les troisièmes régions (110) forment des deuxièmes barrières de potentiel,

et dans lequel la valeur de ladite au moins des première et deuxième impédances (Z1, Z2) est ajustée et des potentiels électriques sont appliqués sur les premières et deuxièmes grilles pour commander les boîtes quantiques.

**Patentansprüche**

1. Vorrichtung (100), mindestens enthaltend:

- eine Halbleiterschicht (102), die erste Bereiche (104) und zweite Bereiche (106) umfasst, die so eingerichtet sind, dass jeder der ersten Bereiche (104) durch zwei der zweiten Bereiche (106) begrenzt ist, die parallel zu einer ersten Richtung ausgerichtet sind, und dass zwei der ersten benachbarten Bereiche (104), die parallel zur ersten Richtung ausgerichtet sind, durch einen der zweiten Bereiche (106) begrenzt sind, und dritte Bereiche (110), die so eingerichtet sind, dass jeder der ersten Bereiche (104) durch zwei der dritten Bereiche (110) begrenzt ist, die parallel zu einer zweiten Richtung ausgerichtet sind, die sich von der ersten Richtung unterscheidet, und dass zwei der ersten Bereiche (104), die parallel zur zweiten Richtung ausgerichtet sind, durch einen der dritten Bereiche (110) begrenzt sind,
- erste elektrostatische Steuergitter, die die ersten leitenden Abschnitte (108) enthalten, die sich parallel zur zweiten Richtung lotrecht zu den zweiten Bereichen (106) erstrecken,
- zweite elektrostatische Steuergitter, die zweite leitende Abschnitte (112) enthalten, die sich parallel zur ersten Richtung lotrecht zu den dritten Bereichen (110) erstrecken,

wobei jedes erste Gitter ein Einstellelement der elektrostatischen Steuerspannung enthält, das erste und zweite Impedanzen (Z1, Z2) bildet, die durch ihre ersten Enden miteinander in Reihe geschaltet sind, wobei ein zweites Ende der ersten Impedanz (Z1) elektrisch mit dem ersten leitenden Abschnitt (108) des ersten Gitters gekoppelt ist und ein zweites Ende der zweiten Impedanz (Z2) elektrisch mit einem dritten leitenden Abschnitt (118) gekoppelt ist, und wobei der Wert mindestens einer der ersten und zweiten Impedanzen (Z1, Z2) einstellbar ist.

2. Vorrichtung (100) nach Anspruch 1, wobei sich die dritten leitenden Abschnitte (118) parallel zur ersten Richtung erstrecken.

3. Vorrichtung (100) nach Anspruch 2, ferner erste dielektrische Abschnitte (116) enthaltend, die jeweils zwischen einem der dritten leitenden Abschnitte (118) und einem der zweiten leitenden Abschnitte (112) angeordnet sind, wobei jeder der zweiten leitenden Abschnitte (112) zwischen der Halbleiterschicht (102) und einem der ersten dielektrischen Abschnitte (116) angeordnet ist.

4. Vorrichtung (100) nach einem der Ansprüche 2 oder 3, ferner zweite dielektrische Abschnitte (120) enthaltend, die jeweils zwischen einem der dritten leitenden Abschnitte (118) und den ersten leitenden Abschnitten (108) angeordnet sind.

5. Vorrichtung (100) nach einem der vorhergehenden Ansprüche, wobei das Einstellelement der elektrostatischen Steuerspannung jedes ersten Gitters ein Speicherelement (122) enthält, das eine der ersten und zweiten Impedanzen (Z1, Z2) bildet, deren Wert einstellbar ist.

6. Vorrichtung (100) nach Anspruch 5, wobei in jedem ersten Gitter das Speicherelement (122) direkt mit dem dritten leitenden Abschnitt (118) oder dem ersten leitenden Abschnitt (108) in Kontakt steht.

7. Vorrichtung (100) nach einem der Ansprüche 5 oder 6, wobei das Einstellelement der elektrostatischen Steuerspannung jedes ersten Gitters einen vierten leitenden Abschnitt (124) enthält, der ein erstes Ende umfasst, das elektrisch mit dem Speicherelement (122) gekoppelt ist, und:

   - ein zweites Ende, das elektrisch mit dem ersten leitenden Abschnitt (108) des ersten Gitters gekoppelt ist, während das Speicherelement (122) direkt mit dem dritten leitenden Abschnitt (118) in Kontakt steht, und die andere der ersten und zweiten Impedanzen (Z1, Z2) bildet oder
   - ein zweites Ende, das elektrisch mit dem dritten leitenden Abschnitt (118) des ersten Gitters gekoppelt ist, während das Speicherelement (122) direkt mit dem ersten leitenden Abschnitt (108) in Kontakt steht, und die andere der ersten und zweiten Impedanzen (Z1, Z2) bildet.

8. Vorrichtung (100) nach Anspruch 7, wobei das erste und das zweite Gitter Gitter-Dielektrika enthalten, die durch eine gleiche Gitter-Dielektrikum-Schicht (114) gebildet sind, die zwischen den zweiten leitenden Abschnitten (112) und der Halbleiterschicht (102) und zwischen den vierten leitenden Abschnitten (124) und der Halbleiterschicht (102) angeordnet ist.

9. Vorrichtung (100) nach einem der Ansprüche 5 bis 8, wobei die Speicherelemente (122) resistive nichtflüchtige Speicher vom Typ OxRAM oder FeRAM oder PCRAM sind.

10. Vorrichtung (100) nach einem der vorhergehenden Ansprüche, wobei die ersten Bereiche (104) in Reihen und Spalten eingerichtet sind, und wobei die erste Richtung senkrecht zur zweiten Richtung ist.

11. Verfahren zur Erstellung einer Vorrichtung (100), die mindestens das Ausführen der folgenden Schritte ausgehend von einer Halbleiterschicht (102) umfasst, die erste Bereiche (104) und zweite Bereiche (106) umfasst, die so eingerichtet sind, dass jeder der ersten Bereiche (104) durch zwei der zweiten Bereiche (106) begrenzt ist, die parallel zu einer ersten Richtung ausgerichtet sind, und dass zwei der ersten benachbarten Bereiche (104), die parallel zur ersten Richtung ausgerichtet sind, durch einen der zweiten Bereiche (106) begrenzt sind, und dritte Bereiche (110), die so eingerichtet sind, dass jeder der ersten Bereiche (104) durch zwei der dritten Bereiche (110) begrenzt ist, die parallel zu einer zweiten Richtung ausgerichtet sind, die sich von der ersten Richtung unterscheidet, und dass zwei der ersten Bereiche (104), die parallel zur zweiten Richtung ausgerichtet sind, durch einen der dritten Bereiche (110) begrenzt sind:

   - Erstellung, auf der Halbleiterschicht (102), von ersten elektrostatischen Steuergittern, die erste leitende Abschnitte (108) enthalten, die sich parallel zur zweiten Richtung lotrecht zu den zweiten Bereichen (106) erstrecken,
   - Erstellung, auf der Halbleiterschicht (102), von zweiten elektrostatischen Steuergittern, die zweite leitende Abschnitte (112) enthalten, die sich parallel zur ersten Richtung lotrecht zu den dritten Bereiche (110) erstrecken,

wobei jedes erste Gitter ein Einstellelement der elektrostatischen Steuerspannung enthält, das erste und zweite Impedanzen (Z1, Z2) bildet, die durch ihre ersten Enden miteinander in Reihe geschaltet sind, wobei ein zweites Ende der ersten Impedanz (Z1) elektrisch mit dem ersten leitenden Abschnitt (108) des ersten Gitters gekoppelt ist und ein zweites Ende der zweiten Impedanz (Z2) elektrisch mit einem dritten leitenden Abschnitt (118) gekoppelt ist, und wobei der Wert mindestens einer der ersten und zweiten Impedanzen (Z1, Z2) einstellbar ist.

12. Verfahren nach Anspruch 11, wobei die zweiten Gitter und die dritten leitenden Abschnitte (118) durch Ausführen der folgenden Schritte erstellt werden:

   - Erstellung, auf der Halbleiterschicht (102), eines Schichtstapels, mindestens in dieser Reihenfolge umfassend: eine Gitter-Dielektrikum-Schicht (114), die gegen die Halbleiterschicht (102) angeordnet ist, eine erste leitende Schicht (130), eine erste dielektrische Schicht (132), eine zweite leitende Schicht (134) und eine zweite dielektrische Schicht (136),
   - Ätzung des Schichtstapels mit Stopp auf der Gitter-Dielektrikum-Schicht (114), so dass die verbleibenden Abschnitte des Schichtstapels die zweiten leitenden Abschnitte (112) bilden, die gegen die Halbleiterschicht (102) angeordnet sind, die ersten dielektrischen Abschnitte (116), die auf den zweiten leitenden Abschnitten (112) angeordnet sind, die dritten leitenden Abschnitte (118), die auf den ersten dielektrischen Abschnitten (116) angeordnet sind, und zweite dielektrische Abschnitte (120), die auf den dritten leitenden Abschnitten (118) angeordnet sind.

13. Verfahren nach Anspruch 12, ferner enthaltend, nach der Erstellung der zweiten Gitter und der dritten leitenden Abschnitte (118):

- Erstellung von dielektrischen Abstandshaltern (126, 127) gegen die Seitenflächen der verbleibenden Abschnitte (112, 116, 118, 120) des Schichtstapels,
- Ätzung eines Teils der dielektrischen Abstandshalter (127), die gegen eine der Seitenflächen der verbleibenden Abschnitte (112, 116, 118, 120) des Schichtstapels angeordnet sind, wodurch ein Zugang zu einer Seitenfläche (138) jedes dritten leitenden Abschnitts (118) gebildet wird,
- konforme Abscheidung einer dritten leitenden Schicht, die die verbleibenden Abschnitte (112, 116, 118, 120) des Schichtstapels bedeckt, die dielektrischen Abstandshalter (126, 127) und Teile der Gitter-Dielektrikum-Schicht (114), die nicht von den verbleibenden Abschnitten (112, 116, 118, 120) des Schichtstapels und den dielektrischen Abstandshaltern (126, 127) bedeckt sind, und die Seitenfläche (138) jedes dritten leitenden Abschnitts (118),
- Ätzung der dritten leitenden Schicht, so dass sich verbleibende Abschnitte (140) der dritten leitenden Schicht parallel zu den Reihen von Qubits erstrecken, und über den zweiten Bereichen (106) angeordnete Teile enthalten,
- Abscheidung einer dritten dielektrischen Schicht (142) auf den verbleibenden Abschnitten (140) der dritten leitenden Schicht, auf Teilen der Gitter-Dielektrikum-Schicht (114), die nicht von den verbleibenden Abschnitten (112, 116, 118, 120) des Schichtstapels bedeckt sind, den dielektrischen Abstandshaltern (126, 127) und den verbleibenden Abschnitten (140) der dritten leitenden Schicht, und auf Teilen der verbleibenden Abschnitte (112, 116, 118, 120) des Schichtstapels und der dielektrischen Abstandshalter (126, 127), die nicht von den verbleibenden Abschnitten (140) der dritten leitenden Schicht bedeckt sind,
- Planarisierung der dritten dielektrischen Schicht (142) und der verbleibenden Abschnitte (140) der dritten leitenden Schicht mit Stopp auf dem zweiten dielektrischen Abschnitt (120), wodurch dritte dielektrische Abschnitte (128) und vierte leitende Abschnitte (124) erstellt werden.

14. Verfahren nach Anspruch 13, ferner enthaltend, nach der Planarisierung der dritten dielektrischen Schicht (142) und der verbleibenden Abschnitte (140) der dritten leitenden Schicht:

- Entfernung eines Teils der vierten leitenden Abschnitte (124), wodurch Hohlräume (144) gebildet werden, deren einer Teil der Seitenwände durch die Seitenfläche (138) jedes dritten leitenden Abschnitts (118) gebildet wird,
- Erstellung, in den Hohlräumen (144), von Speicherelementen (122), die jeweils Teil des Einstellelements der elektrostatischen Steuerspannung eines der ersten Gitter sind und elektrisch mit einem ersten Ende des vierten leitenden Abschnitts (124) des Einstellelements der elektrostatischen Steuerspannung gekoppelt sind, und von vierten dielektrischen Abschnitten (146), die an den Speicherelementen (122) angeordnet sind,
- Erstellung der ersten leitenden Abschnitte (108), so dass sie mit zweiten Enden der vierten leitenden Abschnitte (124) in Kontakt stehen.

15. Verfahren nach Anspruch 13, ferner enthaltend, nach der Planarisierung der dritten dielektrischen Schicht (142) und der verbleibenden Abschnitte (140) der dritten leitenden Schicht:

- Entfernung eines Teils der vierten leitenden Abschnitte (124), wodurch Hohlräume (144) gebildet werden, deren einer Teil der Seitenwände durch die Seitenfläche (138) jedes dritten leitenden Abschnitts (118) gebildet wird,
- Abscheidung von vierten dielektrischen Abschnitten (146) in den Hohlräumen (144),
- Erstellung von Speicherelementen (122), die jeweils Teil des Einstellelements der elektrostatischen Steuerspannung eines der ersten Gitter sind und elektrisch mit einem ersten Ende des vierten leitenden Abschnitts (124) des Einstellelements der elektrostatischen Steuerspannung gekoppelt sind,
- Erstellung der ersten leitenden Abschnitte (108), so dass sie mit den Speicherelementen (122) in Kontakt stehen.

16. Verfahren zum Steuern einer Vorrichtung (100) nach einem der Ansprüche 1 bis 10, wobei:

- die Vorrichtung (100) eine Quantenvorrichtung bildet,
- die ersten Bereiche (104) Quantum-Dots bilden,
- die zweiten Bereiche (106) erste Potentialbarrieren bilden,

- die dritten Bereiche (110) zweite Potentialbarrieren bilden,

und wobei der Wert mindestens der ersten und zweiten Impedanz (Z1, Z2) eingestellt wird und elektrische Potentiale an die ersten und zweiten Gitter angelegt werden, um die Quantum-Dots zu steuern.

## Claims

1. A device (100) including at least:

   - a semiconductor layer (102) comprising first regions (104), second regions (106) arranged such that each of the first regions (104) is delimited by two of the second regions (106) aligned parallel to a first direction and that two of the neighbouring first regions (104) aligned parallel to the first direction are delimited by one of the second regions (106), and third regions (110) arranged such that each of the first regions (104) is delimited by two of the third regions (110) aligned parallel to a second direction different from the first direction and that two of the first regions (104) aligned parallel to the second direction are delimited by one of the third regions (110);
   - first electrostatic control gates including first conductive portions (108) extending parallel to the second direction, in vertical alignment with the second regions (106);
   - second electrostatic control gates including second conductive portions (112) extending parallel to the first direction, in vertical alignment with the third regions (110);

   wherein each first gate includes an electrostatic control voltage adjustment element forming first and second impedances (Z1, Z2) connected in series to each other through their first ends, a second end of the first impedance (Z1) being electrically coupled to the first conductive portion (108) of the first gate and a second end of the second impedance (Z2) being electrically coupled to a third conductive portion (118), and wherein the value of at least one of the first and second impedances (Z1, Z2) is adjustable.

2. The device (100) according to claim 1, wherein the third conductive portions (118) extend parallel to the first direction.

3. The device (100) according to claim 2, further including first dielectric portions (116) each disposed between one of the third conductive portions (118) and one of the second conductive portions (112), each of the second conductive portions (112) being disposed between the semiconductor layer (102) and one of the first dielectric portions (116).

4. The device (100) according to one of claims 2 or 3, further including second dielectric portions (120) each disposed between one of the third conductive portions (118) and the first conductive portions (108).

5. The device (100) according to one of the preceding claims, wherein the electrostatic control voltage adjustment element of each first gate includes a memory element (122) forming one of the first and second impedances (Z1, Z2) whose value is adjustable.

6. The device (100) according to claim 5, wherein, in each first gate, the memory element (122) is directly in contact with the third conductive portion (118) or the first conductive portion (108).

7. The device (100) according to one of claims 5 or 6, wherein the electrostatic control voltage adjustment element of each first gate includes a fourth conductive portion (124) comprising a first end electrically coupled to the memory element (122) and:

   - a second end electrically coupled to the first conductive portion (108) of said first gate when the memory element (122) is directly in contact with the third conductive portion (118), and forming the other of the first and second impedances (Z1, Z2), or
   - a second end electrically coupled to the third conductive portion (118) of said first gate when the memory element (122) is directly in contact with the first conductive portion (108), forming the other of the first and second impedances (Z1, Z2).

8. The device (100) according to claim 7, wherein the first and second gates include gate dielectrics formed by a same gate dielectric layer (114) disposed between the second conductive portions (112) and the semiconductor layer (102) and between the fourth conductive portions (124) and the semiconductor layer (102).

9. The device (100) according to one of claims 5 to 8, wherein the memory elements (122) are OxRAM or FeRAM or PCRAM type resistive non-volatile memories.

10. The device (100) according to one of the preceding claims, wherein the first regions (104) are arranged in rows and columns, and wherein the first direction is perpendicular to the second direction.

11. A method for making a device (100), comprising at least the implementation of the following steps from a semiconductor layer (102) comprising first regions (104), second regions (106) arranged such that each of the first regions (104) is delimited by two of the second regions (106) aligned parallel to a first direction and two of the neighbouring first regions (104) aligned parallel to the first direction are delimited by one of the second regions (106), and third regions (110) arranged such that each of the first regions (104) is delimited by two of the third regions (110) aligned parallel to a second direction different from the first direction and that two of the first regions (104) aligned parallel to the second direction are delimited by one of the third regions (110):

- making, on the semiconductor layer (102), first electrostatic control gates including first conductive portions (108) extending parallel to the second direction, in vertical alignment with the second regions (106);
- making, on the semiconductor layer (102), second electrostatic control gates including second conductive portions (112) extending parallel to the first direction, in vertical alignment with the third regions (110);

wherein each first gate includes an electrostatic control voltage adjustment element forming first and second impedances (Z1, Z2) connected in series to each other through their first ends, a second end of the first impedance (Z1) being electrically coupled to the first conductive portion (108) of the first gate and a second end of the second impedance (Z2) being electrically coupled to a third conductive portion (118), and wherein the value of at least one of the first and second impedances (Z1, Z2) is adjustable.

12. The method according to claim 11, wherein the second gates and the third conductive portions (118) are made by implementing the following steps of:

- making, on the semiconductor layer (102), a stack of layers comprising at least, in this order, a gate dielectric layer (114) disposed against the semiconductor layer (102), a first conductive layer (130), a first dielectric layer (132), a second conductive layer (134), and a second dielectric layer (136);
- etching the stack of layers with a stop on the gate dielectric layer (114), such that the remaining portions of the stack of layers form the second conductive portions (112) disposed against the semiconductor layer (102), first dielectric portions (116) disposed on the second conductive portions (112), the third conductive portions (118) disposed on the first dielectric portions (116), and second dielectric portions (120) disposed on the third conductive portions (118).

13. The method according to claim 12, further including, after making the second gates and third conductive portions (118):

- making dielectric spacers (126, 127) against side faces of the remaining portions (112, 116, 118, 120) of the stack of layers;
- etching part of the dielectric spacers (127) located against one of the side faces of the remaining portions (112, 116, 118, 120) of the stack of layers, forming access to a side face (138) of each third conductive portion (118);
- conformally depositing a third conductive layer, covering the remaining portions (112, 116, 118, 120) of the stack of layers, the dielectric spacers (126, 127), parts of the gate dielectric layer (114) not covered by the remaining portions (112, 116, 118, 120) of the stack of layers and the dielectric spacers (126, 127), and said side wall (138) of each third conductive portion (118);
- etching the third conductive layer such that remaining portions (140) of the third conductive layer extend parallel to the qubit rows and include parts disposed over the second regions (106);
- depositing a third dielectric layer (142) on the remaining portions (140) of the third conductive layer, on parts of the gate dielectric layer (114) not covered by the remaining portions (112, 116, 118, 120) of the stack of layers, the dielectric spacers (126, 127) and the remaining portions (140) of the third conductive layer, and on parts of the remaining portions (112, 116, 118, 120) of the stack of layers and the dielectric spacers (126, 127) not covered by the remaining portions (140) of the third conductive layer;
- planarising the third dielectric layer (142) and the remaining portions (140) of the third conductive layer with a stop on the second dielectric portions (120), making third dielectric portions (128) and fourth conductive portions (124).

14. The method according to claim 13, further including, after planarising the third dielectric layer (142) and the remaining portions (140) of the third conductive layer:

- removing part of the fourth conductive portions (124), forming cavities (144), part of the side walls of which are formed by said side face (138) of each third conductive portion (118);
- making, in the cavities (144), memory elements (122) each being part of the electrostatic control voltage adjustment element of one of the first gates and electrically coupled to a first end of the fourth conductive portion (124) of said electrostatic control voltage adjustment element, and fourth dielectric portions (146) disposed on the memory elements (122);
- making the first conductive portions (108) such that they are in contact with second ends of the fourth conductive portions (124).

15. The method according to claim 13, further including, after planarising the third dielectric layer (142) and the remaining portions (140) of the third conductive layer:

- removing part of the fourth conductive portions (124), forming cavities (144), part of the side walls of which are formed by said side face (138) of each third conductive portion (118);
- depositing fourth dielectric portions (146) in the cavities (144);
- making memory elements (122) each being part of the electrostatic control voltage adjustment element of one of the first gates and electrically coupled to a first end of the fourth conductive portion (124) of said electrostatic control voltage adjustment element;
- making the first conductive portions (108) such that they are in contact with the memory elements (122).

16. A method for controlling a device (100) according to one of claims 1 to 10, wherein:

- the device (100) forms a quantum device;
- the first regions (104) form quantum boxes;
- the second regions (106) form first potential barriers;
- the third regions (110) form second potential barriers;

and wherein the value of said at least one of the first and second impedances (Z1, Z2) is adjusted and electric potentials are applied to the first and second gates to control the quantum boxes.

FIG.1

FIG.2

FIG.3

FIG.4

FIG.5

FIG.6

FIG.7A

FIG.7B

FIG.8A

FIG.8B

FIG.9A

FIG.9B

FIG.10A

FIG.10B

FIG.11A

FIG.11B

FIG.12

FIG.13

FIG.14

FIG.15

## RÉFÉRENCES CITÉES DANS LA DESCRIPTION

**Littérature non-brevet citée dans la description**

- **J. M. BOTER et al.** A sparse spin qubit array with integrated control electronics. *2019 IEEE International Electron Devices Meeting (IEDM)*, 2019, 3141-3144

- **M. VELDHORST et al.** Silicon CMOS architecture for a spin-based quantum computer. *Nat Commun*, 2017, vol. 8, 1766